Europäisches Patentamt

European Patent Office

Office européen des brevets

(11) Veröffentlichungsnummer: **0 221 436 B1**

(12) **EUROPÄISCHE PATENTSCHRIFT**

(45) Veröffentlichungstag der Patentschrift:
16.05.90

(21) Anmeldenummer: 86114551.4

(22) Anmeldetag: 21.10.86

(51) Int. Cl.⁵: **G01C 17/30, H05K 5/00**

(54) Magnetfeldsonde.

(30) Priorität: 24.10.85 DE 3537921

(43) Veröffentlichungstag der Anmeldung:
13.05.87 Patentblatt 87/20

(45) Bekanntmachung des Hinweises auf die Patenterteilung:
16.05.90 Patentblatt 90/20

(84) Benannte Vertragsstaaten:
AT BE CH DE FR GB IT LI NL SE

(56) Entgegenhaltungen:
EP-A- 0 135 933

(73) Patentinhaber: Siemens Aktiengesellschaft,
Wittelsbacherplatz 2, D-8000 München 2(DE)

(72) Erfinder: Golker, Walter, Pfundmayerstrasse 25,
D-8000 München 70(DE)
Erfinder: Tamm, Horst, Dipl.-Ing. (FH),
Karl-Marx-Ring 56, D-8000 München 83(DE)
Erfinder: Wanka, Eberhard, Nürnberger Strasse 8,
D-8060 Dachau(DE)

## Beschreibung

Die Erfindung betrifft eine Magnetfeldsonde mit einem annähernd kreuzförmig gestalteten Kernblech, dessen vier Schenkel nach außen kleeblattförmig zu Polflächen verbreitert sind und das zwischen den Polflächen jeweils in Richtung auf den Mittelpunkt verlaufende Einschnitte aufweist, mit einem flachen, aus Isolierstoff bestehenden Träger, auf welchem das Kernblech ganzflächig aufliegt und der an die Einschnitte des Kernblechs annähernd angepaßte seitliche Einschnitte aufweist, mit zwei kreuzförmig übereinander und im rechten Winkel zueinander in den Einschnitten über den Träger und das Kernblech gewickelten Wicklungen sowie mit einem den Träger aufnehmenden und eine Durchführung für ein Anschlußkabel aufweisenden, zweiteiligen Gehäuse.

Eine derartige Magnetfeldsonde ist bereits in der EP-OS 135 933 beschrieben. Als Träger für das Kernblech und die Wicklungen wird dort die Verwendung einer Leiterplatte vorgeschlagen, die im wesentlichen an die Konturen des Kernblechs angepaßt ist. Bei einer derartigen eben ausgebildeten Leiterplatte ist es allerdings nur durch zusätzliche Maßnahmen möglich, das Kernblech exakt gegenüber den Wicklungen zu positionieren. Eine solche Positionierung ist aber für die spätere Funktion der Magnetfeldsonde sehr wichtig, da bei einer einmal vorgegebenen Dimensionierung einer Auswerteschaltung die Meßwerte nur dann richtig sind, wenn auch das Kernblech immer exakt in der vorgesehenen Lage gegenüber den Wicklungen positioniert ist. Außerdem ist es für die Auswertung natürlich wichtig, das Kernblech mit dem Träger gegenüber den Außenabmessungen des Gehäuses exakt zu positionieren, um eine exakte Richtungsbestimmung mittels der Magnetfeldsonde durchführen zu können. Wenn beispielsweise die Sonde mit ihrem Gehäuse in einem Fahrzeug eingebaut wird, kann die Ausrichtung nur zwischen der Gehäuseaußenseite und der Fahrzeugachse folgen. Dabei muß sichergestellt sein, daß die Wicklungen und das Kernblech bei diesem Einbau eine exakte Lage zur Fahrzeugachse einnehmen.

Aufgabe der Erfindung ist es, eine Magnetfeldsonde der eingangs genannten Art konstruktiv so auszugestalten, daß in einem einfachen Herstellungsvorgang eine richtungsgenaue Positionierung der Wicklung und des Kernbleches auf dem Träger und über den Träger im Gehäuse ermöglicht wird, um auf diese Weise beim Einsatz der Magnetfeldsonde zur Magnetfeldmessung und zur Richtungsbestimmung genaue Meßergebnisse zu erzielen.

Erfindungsgemäß wird diese Aufgabe dadurch gelöst, daß bei einer Magnetfeldsonde der im ersten Teil des Anspruchs 1 genannten Art als Träger ein aus Kunststoff geformter Spulenkörper dient, der an den vier zwischen den Wicklungen liegenden Enden jeweils die Polflächen des Kernblechs tragende Stützlappen sowie auf einer Oberfläche den Konturen des Kernblechs angepaßte Begrenzungsrippen aufweist, daß das Gehäuse aus zwei Halbschalen besteht, daß jede Halbschale eine zentrale Vertiefung zur Aufnahme der Wicklungen und von der zentralen Vertiefung vier kreuzförmig abgehende, flache Ausnehmungen aufweist, die den Konturen der Stützlappen derart angepaßt sind und die in einer derartigen Tiefe, die etwa der halben Dicke der Stützlappen entspricht, Abstützflächen für die Stützlappen bilden, daß der Träger (1) in dem Gehäuse (9) ortsfest gestützt ist.

Mit der Erfindung wird also ein Spulenkörper als Formkörper verwendet, der in seinen Stützlappen eine formgenaue Aufnahme für das Kernblech darstellt, so daß dieses in einfachster Weise eingelegt und damit positioniert werden kann. Außerdem wird das Gehäuse durch zwei Halbschalen gebildet, die jeweils den Stützlappen des Spulenkörpers entsprechende Ausnehmungen aufweisen, so daß der bewickelte Spulenkörper zwischen den beiden Halbschalen des Gehäuses lagerichtig festgelegt wird. Dabei sind keine zusätzlichen Befestigungselemente für den Spulenkörper erforderlich. Allein durch das Einlegen des Spulenkörpers in die vorgesehenen Ausnehmungen und durch Verbindung der beiden Halbschalen wird der Spulenkörper mit den Wicklungen exakt festgelegt und fixiert.

In einer bevorzugten Ausführungsform sind die beiden Halbschalen formidentisch ausgebildet, wobei jede Halbschale symmetrisch zu einer auf der gemeinsamen Trennfläche senkrecht stehenden Mittelebene angeordnete, komplementäre Befestigungselemente sowie symmetrisch zu der Mittelebene ausgeformte Ausnehmungen aufweist. Die Durchführung für das Anschlußkabel kann als eine beiden Halbschalen gemeinsame Bohrung ausgebildet sein, deren Achse in der Schnittlinie zwischen der Trennebene und der Mittelebene liegt. Diese Bohrung kann außerdem in Umfangsrichtung verlaufende Rippen als Zugsicherung für das Kabel aufweisen. Jede Halbschale weist in einer zweckmäßigen Weiterbildung außerdem eine mit der Durchführung in Verbindung stehende zusätzliche Vertiefung auf, in welcher Lötanschlüsse für das Anschlußkabel liegen. In weiterer Ausgestaltung ist außerdem vorgesehen, daß jede Halbschale als Befestigungselemente zumindest auf einer Seite der Mittelebene einen Steckzapfen und auf der gegenüberliegenden Seite in gleichem Abstand von der Mittelebene eine im Durchmesser angepaßte Bohrung aufweist. Zur Bildung einer kraftschlüssigen Befestigung zwischen den Halbschalen können die Wandungen der Bohrung jeweils achsparallele Rippen aufweisen, die beim Ineinanderfügen der beiden Halbschalen eine Durchdringung mit den Steckzapfen ergeben.

Da beim Einbau der Magnetfeldsonde etwa in ein Fahrzeug für die richtige Auswertung auch eine seitenrichtige Anordnung erforderlich ist, kann zumindest die eine der beiden Halbschalen mit einer Markierung versehen sein, die eine Unterscheidung zwischen Ober- und Unterseite der Magnetfeldsonde ermöglicht. Bei formidentischen Halbschalen ist eine solche Unterscheidung zweckmäßigerweise dadurch möglich, daß die beiden Halbschalen aus unterschiedlich gefärbten Kunststoffen bestehen.

Der Spulenkörper besitzt zweckmäßigerweise auf einer seiner Flachseiten eine flächige Ausnehmung zur Aufnahme des Kernblechs, wobei die Tie-

fe der Ausnehmung etwa der Dicke des Kernblechs entspricht. Der Rand der Ausnehmung kann dabei an einer oder mehreren Stellen durch Warmverformung über das Kernblech geprägt sein, um dieses zu fixieren. Weiterhin kann der Spulenkörper mit eingespritzten Lötanschlußfahnen versehen sein. In besonders zweckmäßiger Ausgestaltung ist allerdings vorgesehen, daß der Spulenkörper an seiner der Gehäusedurchführung zugewandten Seite Ausnehmungen zur Steckbefestigung von Lötanschlußfahnen aufweist. Für den Fall, daß das Gehäuse flüssigkeitsdicht abgeschlossen werden soll, können die beiden Halbschalen im Bereich ihrer gemeinsamen Trennebene jeweils eine umlaufende Rippe aufweisen, mittels derer sie, beispielsweise durch Ultraschallverformung, miteinander verschweißt werden können.

Die Erfindung wird nachfolgend an einem Ausführungsbeispiel anhand der Zeichnung näher erläutert. Es zeigt

Fig. 1 eine Magnetfeldsonde mit den beiden Gehäusehälften vor dem Zusammenbau,
Fig. 2 und 3 einen mit dem Kernblech versehenen, unbewikkelten Spulenkörper in zwei Ansichten,
Fig. 4 eine Einzelheit aus Fig. 2 bzw. in perspektivischer Darstellung,
Fig. 5 und 6 eine Gehäusehälfte in zwei Ansichten.

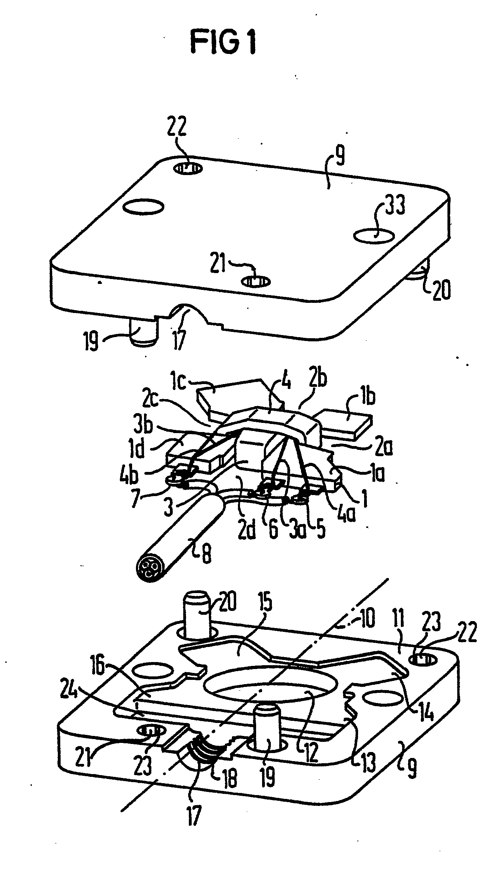

Die in Fig. 1 dargestellte Magnetfeldsonde besitzt einen Spulenkörper 1, der aus Kunststoff gespritzt ist und annähernd kleeblattförmige Gestalt mit vier kreuzförmig von der Mitte ausgehenden und nach außen verbreiterten Stützlappen 1a bis 1d aufweist. Ein in Fig. 1 nicht sichtbares, an der Unterseite des Spulenkörpers 1 angeordnetes Kernblech wird später noch beschrieben. In den Einschnitten 2a bis 2d zwischen den Stützlappen 1a bis 1d sind über den Spulenkörper zwei Wicklungen 3 und 4 in einem Winkel von 90° gegeneinander aufgebracht, deren Wicklungsanfänge bzw. -enden 3a und 3b bzw. 4a und 4b an Lötfahnen 5, 6 und 7 herangeführt sind, welche bei dieser Ausführungsform in den Spulenkörper 1 eingespritzt sind. Ein Anschlußkabel 8 führt von den Lötfahnen 5 bis 7 nach außen zu einer an sich bekannten Auswerteschaltung für die Magnetfeldsonde (solche Schaltungen sind beispielsweise in der DE-AS 31 21 234 bzw. der DE-AS 31 23 180 beschrieben).

Der Spulenkörper 1 mit den Wicklungen 3 und 4 wird in einem Gehäuse untergebracht, welches aus zwei identischen Gehäusehälften bzw. Halbschalen 9 besteht. Diese Halbschalen sind jeweils zu einer durch die Mittellinie 10 gehenden, auf der Trennebene 11 der Halbschalen senkrecht stehenden Mittelebene symmetrisch bzw. komplementär ausgebildet. Symmetrisch zu der Mittelebene besitzt beispielsweise jede Halbschale eine zentrale Vertiefung 12 auf, die zur Aufnahme der Wicklungen 3 und 4 dient. Von dieser zentralen Vertiefung gehen jeweils diagonal zueinander Ausnehmungen 13, 14, 15 und 16 geringerer Tiefe aus, die jeweils zur Aufnahme der Stützlappen 1a bis 1d dienen und in den Konturen zumindest teilweise an diese Stützlappen angepaßt sind, so daß der Spulenkörper 1 in diesen Ausnehmungen 13 bis 16 lagegenau positioniert wird. Die Tiefe der Ausnehmungen 13 bis 16 entspricht etwa der Dicke der Stützlappen 1a bis 1d, so daß beim Aufeinanderfügen der beiden Halbschalen 9 der Spulenkörper mit seinen Stützlappen paßgenau im Gehäuse sitzt.

Die beiden Gehäusehälften 9 besitzen jeweils an einer Seite einen halbzylinderförmig ausgeführten Teil einer Durchführung 17 für das Kabel 8, wobei die Achse der Durchführung genau in der Linie 10 im Schnittpunkt der Mittelebene mit der Trennfläche 11 liegt. Umfangsmäßig verlaufende Rippen 18 dienen dabei als Zugsicherung.

Zur Befestigung der beiden Halbschalen 9 aneinander besitzen sie jeweils Steckzapfen 19 und 20 sowie symmetrisch dazu bezüglich der Mittelebene 10 angeordnete Bohrungen 21 bzw. 22. Durch Rippen 23 in den Bohrungen ergibt sich beim Zusammenfügen der beiden Halbschalen 9 eine kraftschlüssige Befestigung.

Auf der Seite der Durchführung 17 besitzen die beiden Halbschalen außerdem eine weitere Vertiefung 24, die genügend Raum für die Aufnahme der Lötfahnen 5, 6 und 7 bzw. der damit verbundenen Leitungen des Kabels 8.

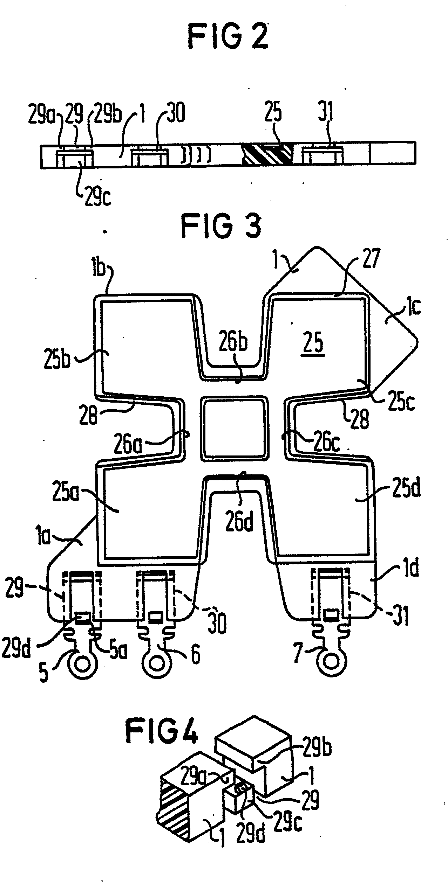

In den Fig. 2 und 3 ist der Spulenkörper 1 allein gezeigt, wobei dieser gegenüber der Fig. 1 gedreht ist, um die Aufnahme des Kernblechs 25 sichtbar zu machen. Dieses Kernblech besitzt ebenfalls im wesentlichen eine kleeblattförmige Form mit vier Polflächen 25a bis 25d, zwischen denen jeweils Einschnitte 26a bis 26d entsprechend den Einschnitten 2a bis 2d des Spulenkörpers 1 vorgesehen sind. Zur Aufnahme besitzt der Spulenkörper 1 eine der Form des Kernblechs 25 im wesentlichen angepaßte Ausnehmung 27, deren Tiefe etwa der Dicke des Kernblechs 25 entspricht. Eine Rippe 28, die diese Ausnehmung zumindest teilweise begrenzt, sichert das Kernblech gegen seitliche Verschiebung. Wie nicht weiter dargestellt, kann diese Rippe an einer oder mehreren Stellen zum Kernblech hin durch Warmverformen geprägt werden, um das Kernblech zusätzlich zu fixieren. Durch Aufbringen der in Fig. 2 und 3 nicht dargestellten Wicklungen 3 und 4 wird das Kernblech 25 ohnehin fest mit dem Spulenkörper 1 verbunden.

In Abweichung zu Fig. 1 sind in den Fig. 2 und 3 die Lötfahnen 5 bis 7 durch Einstecken befestigt. Zu diesem Zweck sind in dem Stützlappen 1a und 1d des Spulenkörpers 1 jeweils von der Stirnseite nach innen verlaufende Ausnehmungen 29, 30 und 31 vorgesehen. Diese Ausnehmungen sind dadurch gebildet, daß beim Ausformen des Spulenkörpers von der Unterseite und von der Oberseite jeweils vorstehende Stempel in der Weise übereinandergreifen, daß an der Oberseite zwei Rippen, beispielsweise 29a und 29b sowie an der Unterseite des Spulenkörpers eine freie Zunge 29c einander gegenüberstehen, so daß die betreffende Lötfahne, beispielsweise 5, zwischen den Rippen und der Zunge eingeklemmt werden kann (siehe Fig. 4). Am freien Ende besitzt die Zunge 29c eine nach oben vorstehende Nase 29d, die in eine entsprechende Ausnehmung 5a der Lötanschlußfahne 5 einrastet und sie gegen Herausfallen sichert (siehe auch Fig. 3). Die Lötfahnen 6 und 7 sind in gleicher Weise durch Einstecken befestigt.

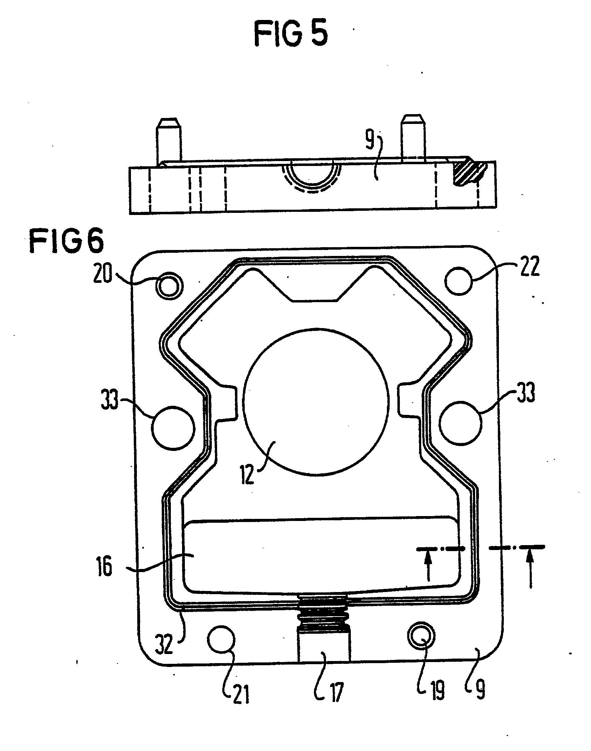

In den Fig. 5 und 6 ist eine Gehäuse-Halbschale 9 nochmals in zwei Ansichten gezeigt. In Abwandlung zu Fig. 1 ist dabei eine zusätzliche, umlaufende Rippe 32 angeformt, welche nach dem Aufeinandersetzen der beiden Halbschalen 9 mittels Ultraschall verformt werden kann, wodurch die beiden Halbschalen wasserdicht miteinander verschweißt werden. In diesem Fall dienen die Zapfen 19 und 20 in den entsprechenden Bohrungen 21 und 22 als Führung. Die beiden Halbschalen besitzen außerdem durchgehende Bohrungen 33, womit die Magnetfeldsonde auf einer Unterlage, beispielsweise in einem Fahrzeug befestigt werden kann.

**Patentansprüche**

1. Magnetfeldsonde mit einem annähernd kreuzförmig gestalteten Kernblech (25), dessen vier Schenkel nach außen kleeblattförmig zu Polflächen (25a bis 25d) verbreitert sind und das zwischen den Polflächen jeweils in Richtung auf den Mittelpunkt verlaufende Einschnitte (26a bis 26d) aufweist, mit einem flachen, aus Isolierstoff bestehenden Träger (1), auf welchem das Kernblech (25) ganzflächig aufliegt und der an die Einschnitte (26a bis 26d) des Kernblechs annähernd angepaßte seitliche Einschnitte (2a bis 2d) aufweist, mit zwei kreuzförmig übereinander und im rechten Winkel zueinander in den Einschnitten über den Träger (1) und das Kernblech (25) gewickelten Wicklungen (3, 4) sowie mit einem den Träger (1) aufnehmenden und eine Durchführung (17) für ein Anschlußkabel (8) aufweisenden, zweiteiligen Gehäuse (9), dadurch gekennzeichnet, daß als Träger ein aus Kunststoff geformter Spulenkörper (1) dient, der an den vier zwischen den Wicklungen (3, 4) liegenden Enden jeweils die Polflächen des Kernblechs (25) tragende Stützlappen (1a bis 1d) sowie auf einer Oberfläche den Konturen des Kernblechs (25) angepaßte Begrenzungsrippen (28) aufweist, daß das Gehäuse aus zwei Halbschalen (9) besteht, daß jede Halbschale (9) eine zentrale Vertiefung (12) zur Aufnahme der Wicklungen (3, 4) und von der zentralen Vertiefung (12) kreuzförmig abgehende, flache Ausnehmungen (13, 14, 15, 16) aufweist, die den Konturen der Stützlappen (1a bis 1d) derart angepaßt sind und die in einer derartigen Tiefe, die etwa der halben Dicke der Stützlappen entspricht, Abstützflächen für die Stützlappen bilden, daß der Träger (1) in dem Gehäuse (9) ortsfest gestützt ist.

2. Magnetfeldsonde nach Anspruch 1, dadurch gekennzeichnet, daß die beiden Halbschalen (9) formidentisch ausgebildet sind, wobei jede Halbschale (9) symmetrisch zu einer auf der Trennfläche (11) senkrecht stehenden Mittelebene (10) angeordnete, komplementäre Befestigungselemente (19, 20, 21, 22) aufweist und daß die Vertiefung (12) bzw. die Ausnehmungen (13 bis 16) jeweils symmetrisch zu der Mittelebene angeordnet sind.

3. Magnetfeldsonde nach Anspruch 1 oder 2, dadurch gekennzeichnet, daß die Durchführung (17) für das Anschlußkabel (8) als beiden Halbschalen (9) gemeinsame Bohrung ausgebildet ist, deren Achse in der Schnittlinie zwischen der Trennebene (11) und der Mittelebene (10) liegt.

4. Magnetfeldsonde nach Anspruch 3, dadurch gekennzeichnet, daß in der Durchführung jeweils in Umfangsrichtung verlaufende Rippen (18) als Zugsicherung angeformt sind.

5. Magnetfeldsonde nach einem der Ansprüche 1 bis 4, dadurch gekennzeichnet, daß jede Halbschale (9) eine mit der Durchführung (17) in Verbindung stehende zusätzliche Vertiefung (24) aufweist, in welcher Lötanschlüsse (5, 6, 7) für das Anschlußkabel (8) liegen.

6. Magnetfeldsonde nach einem der Ansprüche 1 bis 5, dadurch gekennzeichnet, daß jede Halbschale (9) als Befestigungselemente zumindest auf einer Seite der Mittelebene (10) einen Steckzapfen (19, 20) und auf der gegenüberliegenden Seiten im gleichen Abstand von der Mittelebene eine im Durchmesser angepaßte Bohrung (21, 22) aufweist.

7. Magnetfeldsonde nach Anspruch 6, dadurch gekennzeichnet, daß die Wandungen der Bohrungen (21, 22) jeweils achsparallele Rippen (23) aufweisen, die mit den eingesteckten Zapfen (19, 20) eine kraftschlüssige Befestigung ergeben.

8. Magnetfeldsonde nach einem der Ansprüche 1 bis 7, dadurch gekennzeichnet, daß die beiden Halbschalen (9) aus unterschiedlich gefärbtem Kunststoff bestehen.

9. Magnetfeldsonde nach einem der Ansprüche 1 bis 8, dadurch gekennzeichnet, daß der Spulenkörper (1) auf einer Flachseite eine flächige Ausnehmung (27) zur Aufnahme des Kernblechs (25) aufweist, deren Tiefe etwa der Dicke des Kernblechs entspricht.

10. Magnetfeldsonde nach Anspruch 9, dadurch gekennzeichnet, daß das Kernblech (25) an mindestens einer Stelle seines Randes durch Warmverformung des überstehenden Randes (28) des Spulenkörpers (1) fixiert ist.

11. Magnetfeldsonde nach einem der Ansprüche 1 bis 10, dadurch gekennzeichnet, daß der Spulenkörper (1) an der der Durchführung (17) im Gehäuse (9) zugewandten Seite (1a, 1d) Ausnehmungen zur Steckbefestigung von Lötanschlußfahnen (5, 6, 7) aufweist.

12. Magnetfeldsonde nach einem der Ansprüche 1 bis 11, dadurch gekennzeichnet, daß die Halbschalen (9) jeweils eine umlaufende Rippe (32) zur Verschweißung mit der gegenüberliegenden Halbschale aufweisen.

**Claims**

1. Magnetic field probe comprising an approximately cross-shape formed core plate (25) whose four legs are outwardly broadened in cloverleaf-shaped fashion into pole faces (25a to 25d) and which has between the pole faces incisions (26a to 26d) which respectively proceed in a direction towards the centre, comprising a flat carrier (1), consisting of insulating material, on which the core plate (25) rests in surface-wide fashion and has lateral incisions (2a to 2d) approximately matched to the incisions (26a to 26d) of the core plate, comprising two windings (3, 4) wound over the carrier (1) and the core plate (25) cross-wise above one another and at right angles relative to one another in the incisions, as well as a bipartite housing (9) accepting the carrier (1) and having a passage (17) for a connecting cable (8), characterized in that a coil body (1) formed of plastic is employed as the carrier, which coil body has at the four ends lying between the windings (3, 4) supporting tabs (1a to 1d), respectively carrying the pole faces of the core plate (25), and also has on one surface limiting ribs (28), which are matched to the contours of the core plate (25), in that the housing consists of two half shalls (9), in that each half shell (9), has a central depression (12) for the acceptance of the windings (3, 4) and has flat recesses (13, 14, 15, 16), which depart in cross-shaped fashion from the central depression (12), adapted in such a way to the contours of the supporting tabs (1a to 1d) and form supporting faces for the supporting tabs at such a depth, which roughly corresponds to half the thickness of the supporting tabs, that the carrier (1) is supported in a fixed place in the housing (9).

2. Magnetic field probe according to Claim 1, characterized in that the two half shells (9) are fashioned identically in shape, each half shell (9) having complementary fastening elements (19, 20, 21, 22) situated symmetrically to a centre plane (10) residing perpendicularly on the parting surface (11) and in that the depression (12) or the recesses (13 to 16) are respectively arranged symmetrically relative to the centre plane.

3. Magnetic field probe according to Claim 1 or 2, characterized in that the passage (17) for the connecting cable (8) is designed as a bore shared by both half shells, the axis of which bore lies in the intersection line between the parting plane (11) and the centre plane (10).

4. Magnetic field probe according to Claim 3, characterized in that ribs (18) respectively proceeding in a circumferential direction, are formed-on in the passage as protection against pulling.

5. Magnetic field probe according to one of Claims 1 to 4, characterized in that each half shell (9) has an additional depression (24), which communicates with the passage (17) and in which solder terminals (5, 6, 7) for the connecting cable (8) lie.

6. Magnetic field probe according to one of Claims 1 to 5, characterized in that each half shell (9) has as fastening elements a male plug-in member (19, 20), at least on one side of the centre plane (10) and a bore (21, 22) with a matching diameter on the opposite sides and at the same distance from the centre plane.

7. Magnetic field probe according to Claim 6, characterized in that the walls of the bores (21, 22) respectively have ribs parallel to the axis which produce a friction-type fastening with the plugged-in male member (19, 20).

8. Magnetic field probe according to one of Claims 1 to 7, characterized in that the two half shells (9) consist of differently coloured plastic.

9. Magnetic field probe according to one of Claims 1 to 8, characterized in that the coil body (1) has on a flat side a planar recess (27) for the acceptance of the core plate (25), the depth of which recess roughly corresponds to the thickness of the core plate.

10. Magnetic field probe according to Claim 9, characterized in that the core plate (25) is fixed at at least one location of its edge by hot forming of the projecting edge (28) of the coil body (1).

11. Magnetic field probe according to one of Claims 1 to 10, characterized in that the coil body (1) has at the side (1a, 1d) facing the passage (17) in the housing (9) recesses for plug-type fastening of solder terminal lugs (5, 6, 7).

12. Magnetic field probe according to one of Claims 1 to 11, characterized in that the half shells (9) respectively have a peripheral rib (32) for welding to the opposite half shell.

**Revendications**

1. Sonde magnétique comportant une tôle formant noyau approximativement cruciforme, dont les quatre branches s'élargissent vers l'extérieur à la manière de feuilles de trèfle en direction de surfaces polaires (25a à 25d) et qui possède, entre les surfaces polaires, des découpes (26a à 26d) qui s'étendent respectivement en direction du centre, et comportant

un support plat (1) réalisé en un matériau isolant, sur lequel la tôle formant noyau (25) s'applique par toute sa surface et qui comporte des découpes latérales (2a à 2d) approximativement adaptées aux découpes (26a à 26d) de la tôle formant noyau,

deux enroulements (3, 4) enroulés en étant superposés d'une manière croisée à angle droit, dans les découpes au-dessus du support (1) et de la tôle formant noyau (25), et

un boîtier (9) formé de deux éléments, qui loge le support (1) et qui comporte un passage (17) pour un câble de raccordement (8), caractérisée par le fait qu'on utilise, comme support, un corps de bobine (1) formé par moulage d'une matière plastique et qui comporte, sur les quatre extrémités situées entre les enroulements (3, 4), des pattes de support (1a à 1d) portant respectivement les surfaces polaires de la tôle formant noyau (25), ainsi que des nervures de limitation (28) adaptées à une surface des contours de la tôle formant noyau (25),

que le boîtier est formé de deux demi-coques (9), que chaque demi-coque (9) comporte un renforcement central (12) servant à loger les enroulements (3, 4) et des évidements plats (13, 14, 15, 16), qui s'étendent en forme de croix à partir du renforcement central (12), et qui sont adaptés de telle manière au contour des pattes de support (1a à 1d) et forment des surfaces de support pour les pattes de support, à une profondeur correspondant approximativement à la moitié de l'épaisseur des pattes de support, que le support (1) est supporté de façon fixe dans le boîtier (9).

2. Sonde magnétique suivant la revendication 1, caractérisée par le fait que les deux demi-coques (9) possèdent des formes identiques, chaque demi-coque (9) comportant des éléments complémentaires de fixation (19, 20, 21, 22) disposés symétriquement par rapport à un plan médian (10) perpendiculaire à la surface de séparation (11), et que le renfoncement (12) ou les évidements (13 à 16) sont disposés respectivement symétriquement par rapport au plan médian.

3. Sonde magnétique suivant la revendication 1 ou 2, caractérisée par le fait que le passage (17) prévu pour le câble de raccordement (8) est réalisé sous la forme d'un perçage qui est commun aux deux demi-coques (9) et dont l'axe est situé sur la ligne d'intersection entre le plan de séparation (11) et le plan médian (10).

4. Sonde magnétique suivant la revendication 3, caractérisée par le fait que des nervures (18), qui s'étendent respectivement dans la direction circonférentielle, sont formées par façonnage en tant que système de blocage contre une traction.

5. Sonde magnétique suivant l'une des revendications 1 à 4, caractérisée par le fait que chaque demi-coque (9) possède un renfoncement supplémentaire (24), qui est relié au passage (17) et dans lequel sont situées des cosses à souder (5, 6, 7) pour le câble de raccordement (8).

6. Sonde magnétique suivant l'une des revendications 1 à 5, caractérisée par le fait que chaque demi-coque comporte, en tant qu'éléments de fixation, un téton enfichable (19, 20) au moins d'un côté du plan médian (10) et un perçage de diamètre adapté (21, 22), sur le côté opposé, à la même distance du plan médian.

7. Sonde magnétique suivant la revendication 6, caractérisée par le fait que les parois de perçages (21, 22) comportent respectivement des nervures (23) parallèles à l'axe, qui établissent, conjointement avec les tétons enfichés (19, 20), une fixation selon une liaison de force.

8. Sonde magnétique suivant l'une des revendications 1 à 7, caractérisée par le fait que les deux demi-coques (9) sont réalisées avec des matières plastiques colorées différemment.

9. Sonde magnétique suivant l'une des revendications 1 à 8, caractérisée par le fait que le corps de bobine (1) comporte, sur un côté plat, un évidement (27) qui sert à loger la tôle formant noyau (25) et dont la profondeur correspond approximativement à l'épaisseur de la tôle formant noyau.

10. Sonde magnétique suivant la revendication 9, caractérisée par le fait que la tôle formant noyau (25) est fixée en au moins un emplacement de son bord, par déformation à chaud du bord saillant (28) du corps de bobine (1).

11. Sonde magnétique suivant l'une des revendications 1 à 10, caractérisé par le fait que le corps de bobine (1) comporte, sur sa face (1a, 1d) tournée vers le passage (17) ménagé dans le boîtier (9), des évidements permettant la fixation par enfichage de cosses à souder (5, 6, 7).

12. Sonde magnétique suivant l'une des revendications 1 à 11, caractérisée par le fait que les demi-coques (9) possèdent respectivement une nervure circonférentielle (32) permettant leur soudage à la demi-coque opposée.

FIG 1

# FIG 2

29a 29 29b 1 30 25 31

29c

# FIG 3

1b 1 27
1c
25b 26b 25
28 28 25c
26a 26c
25a 25d
1a 26d
29 1d
31
29d 5a 6 30 7
5

# FIG 4

29b
29a 1
29
1 29d 29c

# FIG 5

# FIG 6